Europäisches Patentamt

(19) European Patent Office

Office européen des brevets

(11) Publication number: **0 132 408**
**A2**

## (12) EUROPEAN PATENT APPLICATION

(21) Application number: **84305048.5**

(22) Date of filing: **25.07.84**

(51) Int. Cl.⁴: **C 30 B 25/14**
**// C23C16/44**

(30) Priority: **26.07.83 US 517326**

(43) Date of publication of application: **30.01.85**
**Bulletin 85/5**

(84) Designated Contracting States: **AT BE CH DE FR GB IT LI LU NL SE**

(71) Applicant: **Auclair, Jim, 7021 Alfred De Vigny, Montreal Quebec H4K 2M4 (CA)**

(72) Inventor: **Auclair, Jim, 7021 Alfred De Vigny, Montreal Quebec H4K 2M4 (CA)**

(74) Representative: **Archer, Philip Bruce et al, Urquhart-Dykes & Lord Archdeaconry House Gravel Walk, Peterborough Cambridgeshire PE1 1YU (GB)**

(54) **Method and apparatus for growing layers or producing coatings on a substrate.**

(57) The invention relates to a method and apparatus for growing layers or producing coatings on a substrate particularly as utilized in integrated circuits using organometallic vapour phase epitaxy wherein the constituent materials are passed over the substrate under very low pressure conditions and in very low volumes. The apparatus is particularly adapted to carry out the process and includes an ante-chamber to minimize contamination of the growth chamber.

The present invention relates to a method and apparatus and more particularly, relates to a method and apparatus for coating or growing various materials.

The use of semiconductors in industry is well known and while silicon is the most widely used material, certain other compounds and in particular some III-V and II-VI compounds are utilized for certain applications. However, in manufacturing these III-V and II-VI compounds such as gallium arsenide, various problems have been encountered. In particular, the growth of such compounds to produce a high quality compound with a high yield has been a problem in the past.

One of the best known prior art manufacturing techniques for compounds such as gallium arsenide is liquid phase epitaxy; however, this method suffers from a very limited yield and lack of flexibility. Similarly, the technique of molecular beam epitaxy is a low yield method although it does produce a layer of extremely high quality. Having such a relatively low yield, molecular beam epitaxy is a high cost method.

It is also known in the art to produce layers by use of organometallic vapour phase epitaxy wherein controlled amounts of the constituent materials in a gaseous form are fed into a chamber where a heated substrate resides. The gases decompose and form a deposition layer on the substrate to form a new crystal. Unfortunately, to date this process has used a lot of constituent materials (in the order of 3 liters per minute) and the growth chamber does not permit the introduction of a new substrate without a time consuming changeover.

It is an object of the present invention to provide a growth method suitable for use with III-V and II-VI compounds which is more economic compared to prior art methods.

It is a further object of the present invention to provide an apparatus suitable for the growth or deposition of a coating on a substrate, which apparatus is highly flexible and overcomes problems associated with the prior art.

According to one aspect of the present invention, there is provided the method of growing a coating of a III-V or II-VI compound on a substrate wherein a substrate is placed inside a chamber, is subsequently heated, and a vacuum of between about 0.1 Torr to about 10 Torr is induced in the chamber. Gas containing the desired constituent materials which will form the coating on the substrate are then caused to flow into the chamber at a rate of between 10 cc per minute to about 250 cc per minute.

In a further aspect of the invention, there is provided an apparatus suitable for growing a layer or coating on a substrate. The apparatus includes a growth chamber with associated means for creating a low pressure therein. The growth chamber includes means for supporting the substrate in a desired position within the chamber and means are provided for heating the substrate while in the aforementioned desired position. Organometallic supply means are provided along with gas supply means which will carry the organometallic through gas lines to the growth chamber. Control valves are interposed on the gas lines between the organometallics and the growth chamber.

In a further aspect of the present invention, there is provided an apparatus for coating a substrate, the apparatus including a growth chamber with substrate support means within the growth chamber. There are provided means for heating the substrate while on the substrate support means, an ante-chamber in communication with the growth chamber, and means for creating a reduced pressure in both the ante-chamber and growth chamber. Valve means are provided between the ante-chamber and growth chamber and there are means for transferring the substrate from the ante-chamber to the growth chamber while under reduced pressure.

As used herein, it will be understood that the term "coating" will include the growing of thin crystalline layers on a substrate as is known in semiconductor technology particularly as applied to III-V and II-VI compounds.

The apparatus as previously mentioned, includes a growth chamber. This growth chamber or reactor must be adapted to withstand high pressures and accordingly, is made of a suitable material such as quartz or stainless steel. In a preferred embodiment, for the growth of III-V and II-VI compounds, stainless steel is employed. The growth chamber will also include a plurality of ports both for introduction of materials into the growth chamber, and for monitoring the process. Thus, to this end, there may be provided ports for temperature measurement, heating (such as RF heating), introduction of the constituent materials, pressure measurement, introduction of the substrate, vacuum lines, purging lines and the like. It will be understood that the construction of such vacuum chambers is well known to those skilled in vacuum technology and need not be discussed in greater detail herein.

As is known, use of organometallic vapour phase epitaxy requires the heating of the substrate. Again, one may use various sources of heating such as induction heating, conduction, optical, etc. In the practice of the present invention, induction heating is preferably utilized. Again, such technology is well known and is not detailed herein.

The measurement of the temperature under growth conditions is of substantial importance. Thus, the growth is extremely sensitive to the temperature of the substrate and it is therefore important that the temperature measuring system be accurate and in this respect, the use of certain temperature measuring devices such as thermocouples has been found to possibly lead to errant measurements. Accordingly, it is desirable to use an instrument such as a pyrometer which will measure the temperature of the growth surface rather than a thermocouple which tends to measure the temperature of its surroundings. This minimizes overshoot and undershoot problems In the overall system, the temperature measurement device will be coupled through suitable computer controls to the heating means to control the same.

The pedestal on which the substrate is mounted is preferably formed of high grade graphite coated with an amorphous carbon (glassy carbon coated). It has been known in the art to utilize a silicon carbide coated pedestal; however, this coating suffers from the disadvantage of quick aging with usage, the non-reproducibility of growth, difficulties in cleaning and restricted lifetime. Certain compounds such as gallium arsenide have a great affinity to grow an amorphous or polycrystalline gallium arsenide which may coat the pedestal. Thus, it is important to remove any gallium arsenide left on the pedestal after a growth; this cleaning becomes increasingly difficult as the silicon carbide coatings get damaged.

The pedestal is preferably spaced from the walls a sufficient distance to keep the walls relatively cool versus the raised temperature at the pedestal. In practical terms, the 10 cm. wafer placed on the pedestal will preferably use a 25-30 cm. diameter tube as a growth chamber.

The system will include means for introducing the substrate into the growth chamber and since it is desirable that contamination of the growth chamber by the outside atmosphere does not occur, the system includes an ante-chamber into which the substrate is introduced. This ante-chamber is connected to suitable means for evacuating the atmosphere following which the system will include means for transferring the substrate from the ante-chamber into the growth chamber. As will be appreciated by those skilled in the art, there are commercial systems readily available to perform such a transfer of the substrate.

Between the ante-chamber and the growth chamber there will be provided a valve so that when the ante-chamber is open to place the substrate therein (open to the atmosphere) a gate valve will be closed and thus prevent any pollution of the growth chamber. Subsequently, the ante-chamber will be evacuated, the gate valve open and the substrate transferred to the growth chamber.

The system of the present invention utilizes means for providing a low pressure within both the growth chamber and the ante-chamber. To this end, suitable pumps may be provided; in a preferred embodiment, both rotary pumps and turbo pumps are utilized due to the very low pressures under the preferred operating conditions.

As previously discussed, the reactor chamber will include a port for providing access to a suitable pressure measurement device. This pressure measurement device, which may be of a capacitance monometer type having a sensitivity of 0.001 mm Hg will be suitably interconnected to a control for the vacuum system to maintain the desired low pressure within the reaction chamber.

The apparatus includes a gas supply station for supplying the constituent materials to the growth chamber. To this end, the system will include means for supplying the constituent materials in a gaseous form and some of the materials such as arsine, hydrogen selenide, and hydrogen telluride are readily available in such gaseous form.

Other constituent materials such as various organometallics including trimethyl gallium, trimethyl aluminum, dimethyl zinc, etc. are not supplied in a gaseous form and accordingly, a carrier gas is utilized. Typically, such a carrier gas may be hydrogen.

The system will include control valves which are adapted to precisely control the amount of constituent material being transported to the growth chamber. It is a feature of the present system, which is a low pressure system, that the control or mass flow meter valves are located or interposed in the gas supply line between the source of the organometallic and the growth chamber. Thus, the pressure drop of the low pressure system will occur across the mass flow meter valve instead of across the organometallic material itself which could lead to freezing of the material. Naturally this does not represent the same problem for a constituent material supplied in gaseous form.

The system will further include supply lines and vacuum lines for required purging of the lines by an inert material such as Aragon. Each constituent material will have a separate line which leads to the reactor to minimize cross doping which might otherwise occur.

The system of the invention is completely automated and is interfaced with suitable computer controls. Thus, one may set the parameters at which one wants the system to operate and the computer will automatically do so. Accordingly parameters such as temperature, pressure and flow rates will be constantly measured and automatically adjusted according to preset values. The design and functioning of such computer controls is well known to those skilled in the art and do not form a portion of the present invention. Preferably, associated with the computer are visual readout means and manual override means. Also, the system will include appropriate safety provisions and to this end, a micro-computer may be utilized to continuously verify the operation of all components. If the computer goes "down", a pre-programmed mini-computer will bring the system to a safe standby mode and alert the operator.

The constituent materials utilized in the practice of the method may be any II-VI or III-V compounds which are obtainable in either gaseous or organometallic form. Examples of such constituent materials include arsine in hydrogen ($AsH_3$); hydrogen selenide ($H_2Se$) in hydrogen; hydrogen telluride ($H_2Te$) in hydrogen; organometallic materials including trimethylgallium (($CH_3$)$_3$Ga)(TMG); trimethylaluminum (($CH_3$)$_3$Al)(TMAl); dimethylzinc (($CH_3$)$_2$Zn) (DMZ) diethylzinc (($C_2H_5$)$_2$ Zn) (DEZ), etc.

The manufacture of semi conductors includes, during the growth of an epitaxial layer, the incoporation of certain impurities giving mobile carriers of N or P type. If during the growth of a semi-conductor such as gallium arsenide, DMZ is injected into the growth chamber, the gallium arsenide layer will beocme P type. Similarly, the introduction of hydrogen selenide will render the layer N type. By injecting the doping gases in stages, it is possible to develop P and N layers.

One of the features of the method of the present invention is that an extremely small amount of material is employed during the practice of the method. This has been found to be highly advantageous both in terms of economy and safety.

According to the method of the present invention, one will input into the growth chamber gaseous material at a gas input rate of between 10 to about 250 cc per minute with a preferred input of gaseous material being in the order of between about 20 to about 150 cc per minute. As will be appreciated by those skilled in the art, the precise input will depend on the layers being grown or coating applied, the concentration of constituent materials in the carrier gas, the substrate size, growth chamber size, and the constituent materials per se.

As previously mentioned, the method of the present invention uses a very low pressure and in conjunction with the preferred flow rate, the pressure within the growth chamber will be between 0.1 Torr and about 10 Torr with the preferred range being between about .3 Torr and about 3 Torr.

The other operating parameter of the system is the temperature of the substrate. Again, this can vary according to the particular layer or coating being deposited and the parameters with respect thereto. Typically, however, a substrate temperature in the order of 500°C to about 750°C may be employed.

Having thus generally described the invention, reference will be made to the accompanying drawings illustrating embodiments thereof in which:-

FIGURE 1 is a perspective view of an apparatus according to the present invention;

FIGURE 2 is an elevational view of the growth chamber and associated components;

FIGURE 3 is a schematic view of the gas and organometallic supply system;

FIGURE 4 is an elevational view of the supply and control station; and

FIGURE 5 is a schematic view of the gas lines utilized in the apparatus.

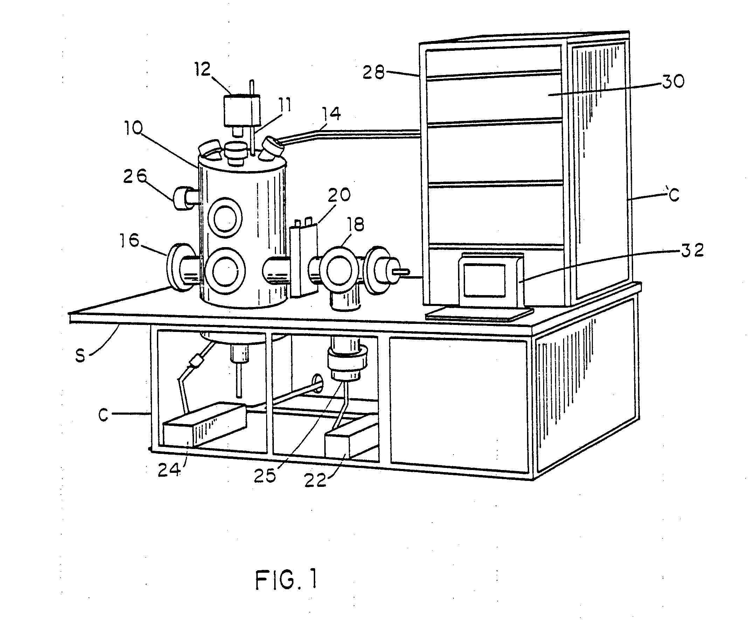

Referring to the drawings in greater detail, an overall view of the apparatus is given in Figure 1, which apparatus includes a reactor 10 having a pyrometer 12 mounted on an appropriate stand 11. A plurality of gas input lines 14 extend between a supply and control station 28 and reactor 10. Reactor 10 includes a pair of ports 16 and 18 for gaining access to the interior of the reactor as will be discussed in greater detail hereinbelow. A gate valve generally designated by reference numeral 20 is interposed between port 18 and reactor 10. As will be seen from Figure 1, reactor 10 is mounted on a supporting surface S and a pair of rotary pumps 22, 24 along with a turbo pump 25 are mounted below surface S in a cabinet generally designated by reference character C. A pressure gauge 26 is mounted on the side of reactor 10 for reading of the interior pressure. Supply and control station 28, mounted in a suitable cabinet designated by reference character C, includes a visual status display portion 30 and a computer control system 32. As will be discussed hereinbelow, mounted interiorly of the station are various supply systems.

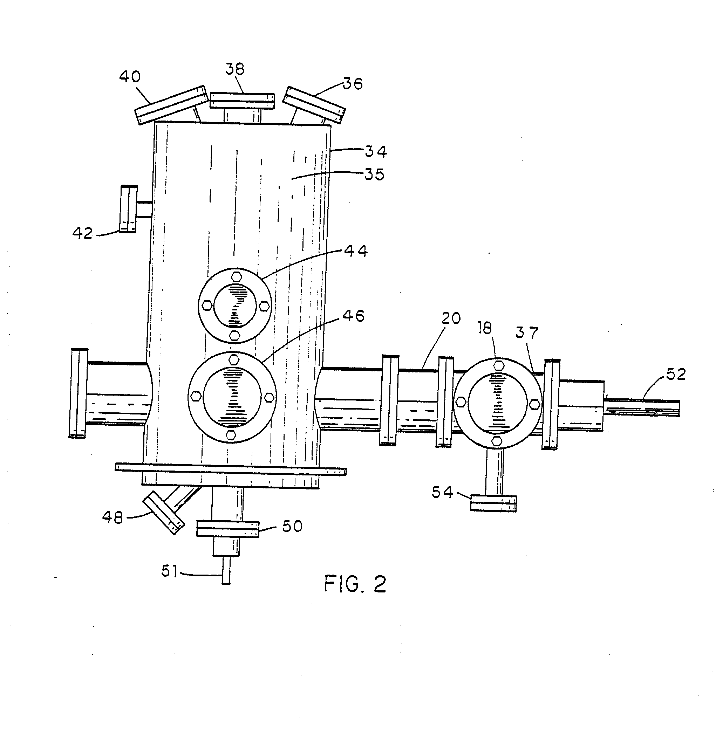

Referring to Figure 2, the reactor is illustrated in greater detail. Reactor 10 includes a cylindrical wall 34, preferably formed of a stainless steel material, which defines a growth chamber 35. Provided within wall 34 are a plurality of ports for various purposes. Port 36 provides access for the gas input lines 14; port 38 provides access for pyrometer 12 to read the temperature of the substrate; port 40 provides access for heating means such as a light source heating; port 44 provides access to inspect the substrate and deposition of material thereon; port 46 also provides visual access for the transfer of the substrate as will be discussed hereinbelow; port 48 provides access for pump unit 24; and port 50 is located at the base of reactor 10. There may also be provided other ports including one for RF heating. The design and arrangement of such ports is well known to those knowledgeable in the vacuum technology.

The apparatus includes a vertical feed arm 51 and a horizontal feed arm 52. In operation, horizontal feed arm 52 brings the substrate/pedestal from a position at port 18 to a position adjacent port 46. Vertical feed arm 51 is then adapted to take the substrate/pedestal to a position proximate port 44 where it will be heated and exposed to the gaseous atmosphere for deposition of the desired coating. It will be understood that the control arms and associated transfer mechanism are normal commercial items.

As aforementioned, heating means (not shown) are used to heat the substrate. Although there are different means of heating the substrate, a preferred means is RF heating which is utilized in conjunction with pyrometer 12 for controlling the substrate temperature. The pedestal (not shown) is desirably spaced a distance from walls 34 of growth chamber 35. It has been found that adequate spacing is desirable for most efficient operation of the apparatus. In practice, growth chamber 35 may have a diameter of 12 inches which would be suitable for a wafer having a 4 inch dimension.

The system incorporates an inlet port 18 through which the substrate may be placed on the pedestal within an ante-chamber 37. Ante-chamber 37 is, however, isolated from growth chamber 35 by means of gate valve 20. Ante-chamber 37 has a port 54 in communication with pumps 22 for evacuating the chamber. Thus, the contamination of the interior of growth chamber 35 is minimized.

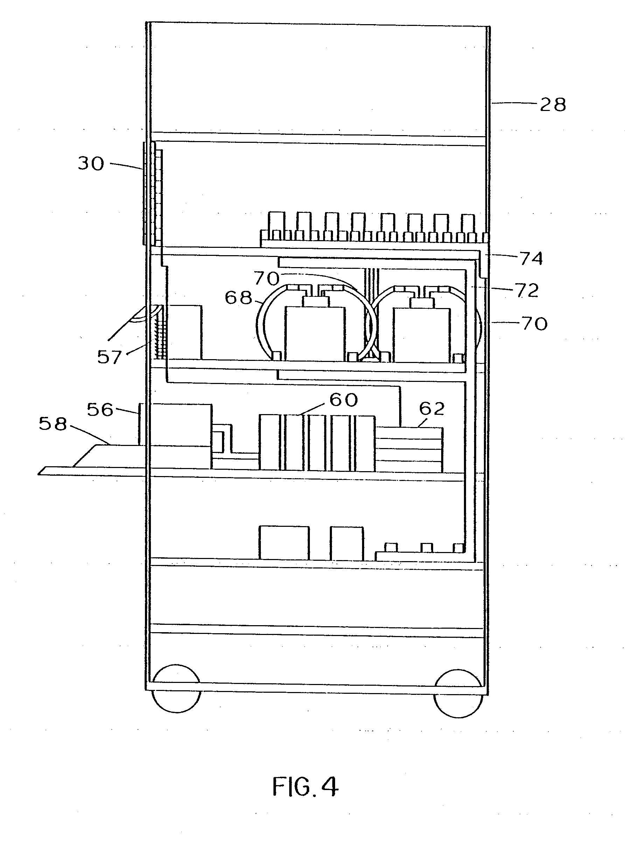

Referring to Figure 4, supply and control station 28, includes on a first level a control computer 32 which consists of the computer 58 with associated display screen 56. A standard card arrangement 60 with interface 62 interconnects t visual status display board 30. The overall system may include a manual valve operator generally designated by reference numeral 57.

On a further level of supply and control station 28 are mounted supplies of organometallic material 66 with inlet and outlet lines 68 and 70 operatively connected thereto. Station 28 further includes appropriate air valve lines 72 and vacuum lines 74.

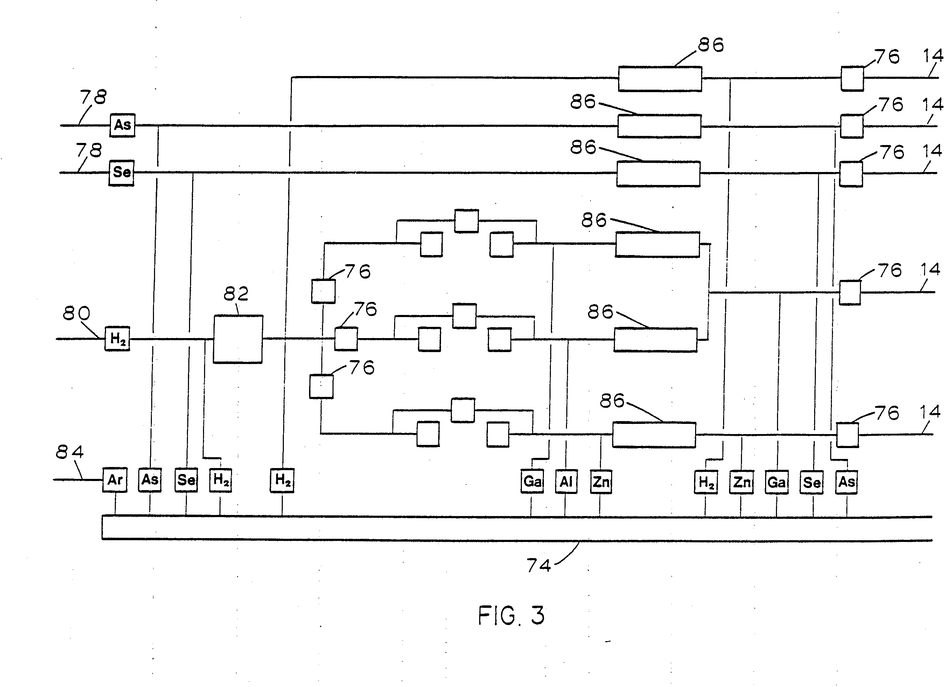

Turning to Figure 3, there is shown a schematic of the arrangement of various valves associated with the supply system. In the schematic, reference numeral 76 designates a valve. As seen, there are provided a plurality of input lines 78 which may be utilized for dopants. A line 80 brings a suitable carrier gas such as hydrogen to a hydrogen purifier generally designated by reference numeral 82. A further purging line 84 is provided. The system will include a plurality of mass flow meter valves generally designated by reference numeral 86 for controlling the amount of material fed to input lines 14. It will be noted that mass flow meter valves 86 are, in the case of the organometallics, located between the source of organometallic and the growth chamber. Thus, in operation, those constituent materials available in a normal gaseous form may flow through lines 78, mass flow meter valves 86, to lines 14. The organometallic materials, on the other hand, will have a carrier gas such as hydrogen passed therethrough and subsequently through mass flow meter valves 86 to input lines 14. It will be noted from the interconnections that the system may readily be purged using purging line 84 and vacuum line 74 with appropriate stop valves 76 providing for a great flexibility of operation.

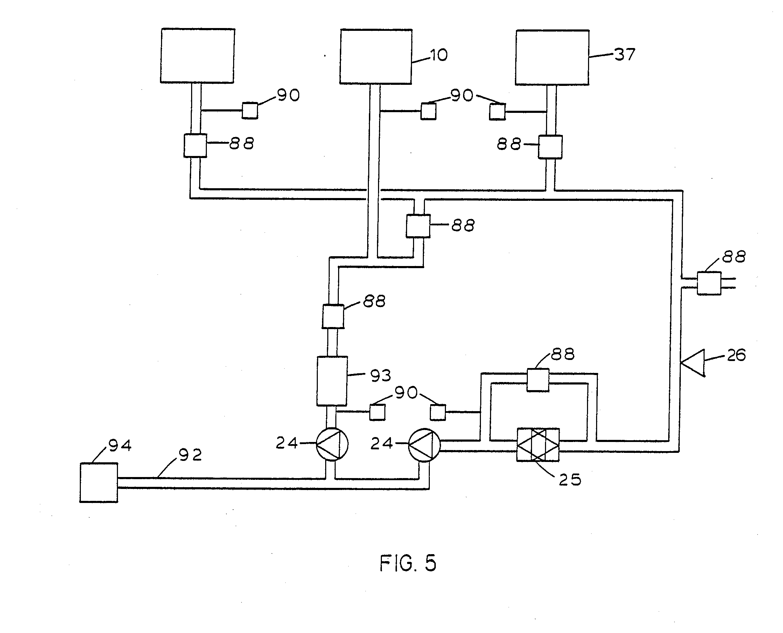

Figure 5 is a schematic of the pumping system associated with the device. In the drawing, reference numberal 88 generally indicates a stop valve while reference numeral 90 indicates valves on a line to a source of argon back fill for use with the system. As will be seen, the system is flexible and permits the use of turbo pump 25 in association with pump 24 if desired. A four line trap 93 is provided with line 92 leading to charcoal drum filter 94.

In conjunction with the above, the system may include pre and post-treatment stations. Thus, one may incorporate treatments such as with an ion beam etcher in the system.

With the practice of the present invention, one is able to use extremely low flow rates of between 10 cc per minute to about 250 cc per minute of total gas flow. This is contrary to previous expectations where it was believed that high flow rates would be necessary in order to grow a suitable layer on the substrate. This flow rate is substantially independent of the growth chamber size and concentration of the constituent materials in the carrier gas. Thus, one could flow through a higher amount of carrier gas while maintaining the flow rate of the actual constituent materials at the same rate. However, it has been found that this will provide an inferior growth compared to the aforementioned flow rates.

In conjunction with the above, and in the particular case of growing gallium arsenide, it has further been found that a molecular ratio of the arsine to gallium is kept relatively low and in particular, that the molecular ratio be between 1 and 10. When the ratio is at the lower end of the scale, one can grow a P type layer and at the higher end, one can grow an N type layer.

It will be understood that various standard devices may be used in conjunction with the present invention. Thus, for example, means will be provided for maintaining the temperature of the organometallic materials at a desired value; the temperature control means will desirably be controlled by the computer in its fully automatic mode.

1

A method of growing a coating of a III-V or II-VI compound on a substrate, which method comprises the steps of placing a substrate inside a chamber, heating the substrate, inducing a vacuum in said chamber of between about 0.1 Torr to about 10 Torr, and flowing a gas containing desired constituent materials forming the layer to be grown at a rate of between 10 cc per minute to about 250 cc per minute.

2 The method of claim 1 wherein said constituent materials are flowed to said chamber at a rate of between 20 cc per minute to about 150 cc per minute.

3 The method of claim 2 wherein the step of heating said substrate comprises the step of heating the substrate to a temperature of between 500°C and 750°C.

4

A method of growing a layer of gallium arsenide on a substrate comprising the steps of placing the substrate inside a chamber, heating the substrate, inducing a vacuum in said chamber of between about 0.1 Torr to about 10 Torr, flowing a carrier gas through trimethylgallium, passing said carrier gas with arsine in hydrogen into said growth chamber at a rate of between 10 cc per minute to about 50 cc per minute.

5 The method of claim 4 wherein said substrate is heated to a temperature of about 600°C.

6 The method of claim 4 wherein the molecular ratio of arsine to gallium in said chamber is between 1:1 to 1:10.

7 The method of claim 4 including the step of introducing into the growth chamber during the growth of a layer a doping gas.

8 The method of claim 7 wherein doping gases are introduced into said growth chamber alternately to give alternating P and N type layers.

9 The method of claim 8 wherein said doping gases are hydrogen selenide and dimethylzinc.

10 An apparatus suitable for growing an organometallic coating on a substrate comprising a growth chamber, means for creating a low pressure in said growth chamber, means for supporting the substrate in a desired position within said chamber, means for heating the substrate while in said desired position, organometallic supply means, gas supply lines from a gas supply to said organometallics and through control valves interposed on said gas supply lines between said organometallics and said growth chamber.

11 The apparatus of claim 10 further including pressure sensing means.

12 The apparatus of claim 11 further including temperature sensing means.

13 The apparatus of claim 10 further including computer control means co-operatively associated with pressure measurement means and temperature measurement means to automatically control said temperature, pressure and said control valves.

14 An apparatus for growing a III-V or II-VI compound on a substrate, comprising a growth chamber, substrate support means within said growth chamber, means for heating said substrate while on said substrate support means, an ante-chamber associated with said growth chamber, means for creating a reduced pressure in both said ante-chamber and said growth chamber, valve means and means for transferring the substrate from said ante-chamber to said growth chamber while under reduced pressure.

FIG.1

0132408

FIG. 2

0132408

FIG. 3

FIG.4

FIG. 5

0132408